# EUROPEAN PATENT APPLICATION

(11) **EP 4 757 500 A1**
(43) Date of publication of application: **10.06.2026**
(21) Application number: 25217474.3
(22) Date of filing: 20.11.2025
(51) Int. Cl.: H05K 1/02, H05K 1/11, H05K 1/185, H05K 3/28, H05K 3/46

(54) **DOUBLE-SIDED CHIP-EMBEDDED CIRCUIT BOARD AND MANUFACTURING METHOD THEREFOR**

(30) Priority: 05.12.2024 CN 202411782079
(71) Applicant: ZF Friedrichshafen AG, 88046 Friedrichshafen (DE)
(72) Inventor: XU, Qing, Shanghai 201615 (CN); YUAN, George, Shanghai 201615 (CN)
(74) Representative: Nowack, Linda

(57) **Abstract**

The present disclosure relates to the technical field of vehicle parts and components, and provides a double-sided chip-embedded circuit board and a manufacturing method therefor. The double-sided chip-embedded circuit board includes: a prefabricated circuit board, with each of an upper surface and a lower surface thereof being a conductive layer; a chip packaging unit embedded in the prefabricated circuit board; an upper conductive film layer adhered to the upper surface of the prefabricated circuit board by an upper dielectric layer and covering the chip packaging unit, where an electrode of the chip packaging unit is led out to a surface of the upper conductive film layer; and a lower conductive film layer adhered to the lower surface of the prefabricated circuit board by a lower dielectric layer and exposing a backside of the chip packaging unit, where heat dissipation fins are provided on the backside of the chip packaging unit. In the present disclosure, the conductive film layer is adhered to each of the upper surface and the lower surface of the prefabricated circuit board, with the upper conductive film layer being configured for leading out of the electrode of the chip packaging unit, and the lower conductive film layer being configured for layout of other functional modules of the circuit board, such that the double-sided chip-embedded circuit board has a reasonable electrical performance layout and better stability.

## Description

### Technical Field

The present disclosure relates to the technical field of vehicle parts and components, and in particular, to a double-sided chip-embedded circuit board and a manufacturing method therefor.

### Background Art

In vehicle inverters, a design of chip embedding in a circuit board is used to improve the integration level of the circuit board.

In traditional designs of chip embedding in a circuit board, only a front side of the circuit board is utilized. After a chip is embedded in the circuit board, wiring and other functional module designs are carried out on the front side of the circuit board, with little use of a backside of the circuit board. Implementation of all electrical performances on the front side of the circuit board results in a crowded layout on the front side of the circuit board and poor stability.

It should be noted that information disclosed in the above background art section is only used to enhance the understanding of the background of the present disclosure, and therefore may include information that does not constitute the prior art known to those of ordinary skill in the art.

### Summary

In view of this, the present disclosure provides a double-sided chip-embedded circuit board and a manufacturing method therefor. After a chip packaging unit is embedded in a prefabricated circuit board, conductive film layers are adhered to an upper surface and a lower surface of the prefabricated circuit board, respectively, with the upper conductive film layer being configured for leading out of an electrode of the chip packaging unit, and the lower conductive film layer being configured for layout of other functional modules of the circuit board, such that the double-sided chip-embedded circuit board has a reasonable electrical performance layout and better stability.

According to an aspect of the present disclosure, a double-sided chip-embedded circuit board is provided. The double-sided chip-embedded circuit board includes: a prefabricated circuit board, with each of an upper surface and a lower surface of the prefabricated circuit board being a conductive layer; a chip packaging unit embedded in the prefabricated circuit board; an upper conductive film layer adhered to the upper surface of the prefabricated circuit board by an upper dielectric layer and covering the chip packaging unit, where an electrode of the chip packaging unit is led out to a surface of the upper conductive film layer; and a lower conductive film layer adhered to the lower surface of the prefabricated circuit board by a lower dielectric layer and exposing a backside of the chip packaging unit, where heat dissipation fins are provided on the backside of the chip packaging unit.

In some embodiments, the heat dissipation fins are uniformly distributed, and a diameter of each heat dissipation fin and/or a gap between adjacent heat dissipation fins is 1 mm to 2 mm.

In some embodiments, the chip packaging unit includes a bus bar and a chip unit embedded in the bus bar, and the heat dissipation fins are provided on a backside of the bus bar, forming a structure that is recessed into the bus bar.

In some embodiments, there is a bus bar having a thickness of at least 1 mm between the heat dissipation fins and the chip unit.

In some embodiments, the heat dissipation fins are connected to the backside of the chip packaging unit, forming a structure that protrudes from the chip packaging unit.

In some embodiments, the heat dissipation fins are welded or adhesively bonded to the backside of the chip packaging unit.

In some embodiments, the heat dissipation fin s are recessed into an end face of the lower conductive film layer, such that a cooler insertion slot is reserved between the backside of the chip packaging unit and the lower conductive film layer and the lower dielectric layer.

In some embodiments, the double-sided chip-embedded circuit board further includes:
a pad provided on the surface of the upper conductive film layer and connected to an electrode lead-out wire of the chip packaging unit; and a protective layer covering an area of the upper conductive film layer that is not covered by the pad and being flush with the pad.

According to another aspect of the present disclosure, a manufacturing method for a double-sided chip-embedded circuit board is provided, which is used for manufacturing a double-sided chip-embedded circuit board according to any one of the above embodiments. The manufacturing method includes: providing a prefabricated circuit board, with each of an upper surface and a lower surface of the prefabricated circuit board being a conductive layer; embedding a chip packaging unit in the prefabricated circuit board; sequentially adhering an upper dielectric layer and an upper conductive film layer to the upper surface of the prefabricated circuit board, and forming an electrode lead-out wire in each of the upper dielectric layer and the upper conductive film layer to lead out an electrode of the chip packaging unit to a surface of the upper conductive film layer; and sequentially adhering a lower dielectric layer and a lower conductive film layer to the lower surface of the prefabricated circuit board, and forming a slot in each of the lower dielectric layer and the lower conductive film layer to expose a backside of the chip packaging unit, where heat dissipation fins are provided on the backside of the chip packaging unit, or the heat dissipation fins are further formed on the backside of the chip packaging unit.

In some embodiments, the manufacturing method further includes: forming a pad on the surface of the upper conductive film layer, such that the pad is connected to an electrode lead-out wire of the chip packaging unit; and forming a protective layer on the surface of the upper conductive film layer, such that the protective layer covers an area of the upper conductive film layer that is not covered by the pad and such that the protective layer is flush with the pad.

Compared with the prior art, the present disclosure has at least the following beneficial effects.

In the double-sided chip-embedded circuit board according to the present disclosure, after the chip packaging unit is embedded in the prefabricated circuit board, the conductive film layers are adhered to the upper surface and the lower surface of the prefabricated circuit board, respectively, with the upper conductive film layer being configured for leading out of the electrode of the chip packaging unit, connection to a power supply, and connection to drive/control and other circuit modules of an inverter, and the lower conductive film layer being configured for layout of other functional modules of the circuit board, such that the double-sided chip-embedded circuit board has a reasonable electrical performance layout and better stability.

The heat dissipation fins are provided on the backside of the chip packaging unit, and the backside of the chip packaging unit is exposed from the lower conductive film layer and the lower dielectric layer, such that the double-sided chip-embedded circuit board has better heat dissipation performance, avoiding an impact on the heat dissipation of the chip packaging unit due to the addition of the lower conductive film layer.

Furthermore, in the present disclosure, a layer of conductive film is provided on each of the upper surface and the lower surface of the prefabricated circuit board, such that the double-sided chip embedded circuit board is formed into a four-layer board structure (including four conductive layers). This not only improves the electrical performance of the double-sided chip-embedded circuit board, but also avoids an increase in cost due to an increasing number of conductive layers, thereby achieving a balance between cost and performance.

It should be understood that the above general description and the following detailed description are only exemplary and explanatory, and cannot limit the present disclosure.

### Brief Description of the Drawings

The accompanying drawings herein, which are incorporated into and constitute a part of the description, illustrate embodiments consistent with the present disclosure and, together with the description, are used to explain principles of the present disclosure. Obviously, the accompanying drawings described below show merely some of the embodiments of the present disclosure, and those of ordinary skill in the art would also have obtained other accompanying drawings according to these accompanying drawings without any creative effort.
FIG. 1 is a schematic view of a sectional structure of a double-sided chip-embedded circuit board according to an embodiment of the present disclosure;
FIG. 2 is a schematic view of a sectional structure of another double-sided chip-embedded circuit board according to an embodiment of the present disclosure;
FIG. 3 is a schematic diagram of steps of a manufacturing method for a double-sided chip-embedded circuit board according to an embodiment of the present disclosure; and
FIG. 4 is a schematic diagram of steps of another manufacturing method for a double-sided chip-embedded circuit board according to an embodiment of the present disclosure.

### Detailed Description of Embodiments

Now exemplary implementations will be described more fully with reference to the accompanying drawings. However, the exemplary implementations can be implemented in many forms and should not be construed as being limited to the implementations described herein. On the contrary, these implementations are provided to make the present disclosure more thorough and complete, and to fully convey the concept of the exemplary implementations to those skilled in the art.

The accompanying drawings are only schematic illustrations of the present disclosure, and are not necessarily drawn to scale. In the accompanying drawings, the same reference numerals denote the same or similar parts, and thus the repeated description thereof will be omitted. The processes shown in the accompanying drawings are only exemplary illustrations, and do not necessarily include all steps. For example, some steps can be divided, and some steps can be combined or partially combined, and the actual execution order thereof may be changed based on actual conditions.

In the description of the present disclosure, it should be noted that orientations or positional relationships indicated by the terms such as "upper" and "lower" are based on orientations or positional relationships shown in the drawings, which is only for convenience of describing the present disclosure and simplifying the description, rather than indicating or implying that an apparatus or an element referred to must have a specific orientation or be constructed and operated in a specific orientation, and therefore cannot be construed as limiting the present disclosure. Moreover, in the description of the present disclosure, when it is said that a device is "connected" to another device, this includes not only the case of direct connection but also the case of indirect connection through other elements.

It should be noted that the embodiments in the present disclosure and features of the various embodiments can be combined with each other without conflict.

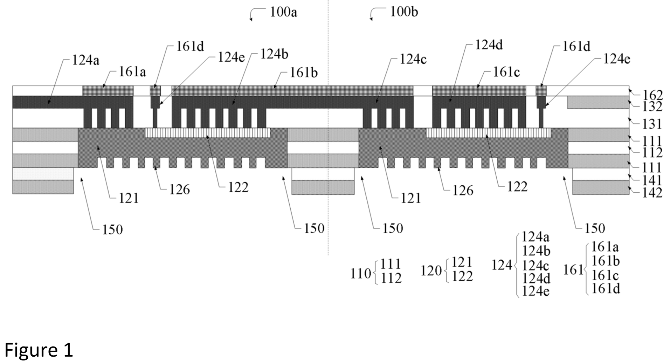

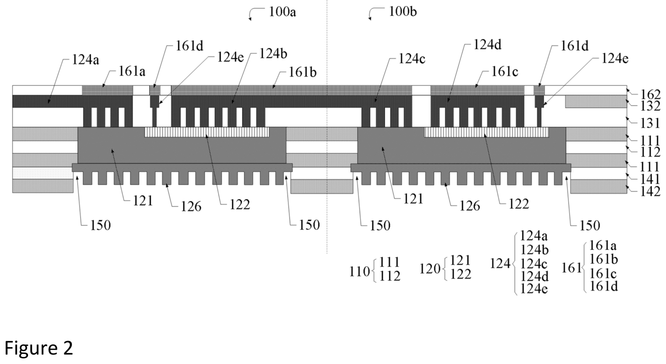

FIG. 1 illustrates a sectional structure of a double-sided chip-embedded circuit board, and FIG. 2 illustrates a sectional structure of another double-sided chip-embedded circuit board. Referring to FIG. 1 and FIG. 2, the double-sided chip-embedded circuit board according to an embodiment of the present disclosure includes:
a prefabricated circuit board 110, with each of an upper surface and a lower surface of the prefabricated circuit board 110 being a conductive layer 111;
a chip packaging unit 120 embedded in the prefabricated circuit board 110;
an upper conductive film layer 132 adhered to the upper surface of the prefabricated circuit board 110 by an upper dielectric layer 131 and covering the chip packaging unit 120, where an electrode of the chip packaging unit 120 is led out to a surface of the upper conductive film layer 132; and
a lower conductive film layer 142 adhered to the lower surface of the prefabricated circuit board 110 by a lower dielectric layer 141 and exposing a backside of the chip packaging unit 120, where heat dissipation fins 126 are provided on the backside of the chip packaging unit 120.

Between the two layers of upper and lower conductive layers 111 of the prefabricated circuit board 110, a substrate 112 formed of materials such as a resin mixture is sandwiched, and an upper surface and a lower surface of the substrate 112 may each be covered with a copper film to form the two layers of upper and lower conductive layers 111. The chip packaging unit 120 is embedded in the prefabricated circuit board 110, and the electrical connection between the chip packaging unit and the prefabricated circuit board 110 may be implemented through the conductive layer 111 and a bus bar 121 of the chip packaging unit 120. The upper conductive film layer 132 and the lower conductive film layer 142 may be copper layers, and the upper dielectric layer 131 and the lower dielectric layer 141 may be resin compositions, but are not limited thereto.

In the double-sided chip-embedded circuit board according to the present disclosure, after the chip packaging unit 120 is embedded in the prefabricated circuit board 110, the conductive film layers are adhered to the upper surface and the lower surface of the prefabricated circuit board 110, respectively, with the upper conductive film layer 132 being configured for leading out of the electrode of the chip packaging unit 120, connection to a power supply, and connection to drive/control and other circuit modules of an inverter, and the lower conductive film layer 142 being configured for layout of other functional modules of the circuit board, such that the double-sided chip-embedded circuit board has a reasonable electrical performance layout and better stability.

The heat dissipation fins 126 are further provided on the backside of the chip packaging unit 120, and the backside of the chip packaging unit 120 is exposed from the lower conductive film layer 142 and the lower dielectric layer 141, such that the double-sided chip-embedded circuit board has better heat dissipation performance, avoiding an impact on the heat dissipation of the chip packaging unit 120 due to the addition of the lower conductive film layer 142.

Furthermore, in the present disclosure, a layer of conductive film is provided on each of the upper surface and the lower surface of the prefabricated circuit board 110, such that the double-sided chip-embedded circuit board is formed into a four-layer board structure (including four conductive layers, which are respectively the two layers of upper and lower conductive layers 111 of the prefabricated circuit board 110, and the upper conductive film layer 132 and the lower conductive film layer 142). This not only improves the electrical performance of the double-sided chip-embedded circuit board, but also avoids an increase in cost due to an increasing number of conductive layers, thereby achieving a balance between cost and performance.

In some embodiments, the heat dissipation fins 126 are uniformly distributed, and a diameter of each heat dissipation fin 126 and/or a gap between adjacent heat dissipation fins 126 is 1 mm to 2 mm. The heat dissipation fins 126 can increase the heat dissipation area, improve the heat dissipation performance of the chip packaging unit 120, and further enhance the electrical performance and stability of the double-sided chip-embedded circuit board. In a case where the heat dissipation fins 126 possess a certain strength and there is a certain gap between adjacent heat dissipation fins, a finer and denser arrangement of the heat dissipation fins 126 indicates a better heat dissipation effect. In an specific implementation, the diameter of the heat dissipation fin 126 and the gap between adjacent heat dissipation fins 126 are both 1 mm, which is not limited thereto.

In some embodiments, the chip packaging unit 120 includes a bus bar 121 and a chip unit 122 embedded in the bus bar 121. The heat dissipation fins 126 are provided on a backside of the bus bar 121, forming a structure that is recessed into the bus bar 121. For details, reference can be made to FIG. 1. In this embodiment, the heat dissipation fins 126 may be formed by forming slots on the backside of the bus bar 121.

Further, in this embodiment, there is a bus bar 121 having a thickness of at least 1 mm between the heat dissipation fins 126 and the chip unit 122. This ensures that the chip unit 122 is supported by the bus bar 121 with an appropriate thickness, such that the chip unit 122 is protected, when the heat dissipation fins 126 are provided on the backside of the bus bar 121.

In some embodiments, the heat dissipation fins 126 are connected to the backside of the chip packaging unit 120, forming a structure that protrudes from the chip packaging unit 120. For details, reference can be made to FIG. 2. In this embodiment, the heat dissipation fins 126 may be formed as independent members and connected to the backside of the chip packaging unit 120 by means of welding, adhesively, etc., thereby forming a structure that protrudes from the bus bar 121.

Further, in some embodiments, regardless of whether the heat dissipation fins 126 are recessed into the bus bar 121 or protrude from the bus bar 121, the heat dissipation fins 126 are recessed into an end face of the lower conductive film layer 142, such that a cooler insertion slot 150 is reserved between the backside of the chip packaging unit 120 and the lower conductive film layer 142 and the lower dielectric layer 141. The cooler insertion slot 150 facilitates the insertion of a cooler. The cooler can cool the heat dissipation fins 126, further improve the heat dissipation performance of the chip packaging unit 120, and thus enhance the electrical performance and stability of the double-sided chip-embedded circuit board.

In some embodiments, the double-sided chip-embedded circuit board further includes:
a pad 161 provided on the surface of the upper conductive film layer 132 and connected to an electrode lead-out wire 124 of the chip packaging unit 120; and a protective layer 162 covering an area of the upper conductive film layer 132 that is not covered by the pad 161 and being flush with the pad 161.

The pad 161 is configured to electrically connect the electrode lead-out wire 124 of the chip packaging unit 120 to other electronic components of the inverter. The double-sided chip-embedded circuit board shown in FIG. 1 and FIG. 2 is specifically a half-bridge module in a power module of the inverter, including an upper bridge region 100a and a lower bridge region 100b. A pad 161a connected to a drain lead-out wire 124a of the chip packaging unit 120 in the upper bridge region 100a is configured to be connected to a positive pole of a direct-current power supply. A source lead-out wire 124b of the chip packaging unit 120 in the upper bridge region 100a is connected in series with a drain lead-out wire 124c of the chip packaging unit 120 in the lower bridge region 100b through a pad 161b, where the pad 161b is configured to be connected to a motor winding driven by the inverter. A pad 161c connected to a drain lead-out wire 124d of the chip packaging unit 120 in the lower bridge region 100b is configured to be connected to a negative pole of the direct-current power supply. A pad 161d connected to gate lead-out wires 124e of the chip packaging unit 120 in the upper bridge region 100a and the lower bridge region 100b is configured to be connected to a control circuit of the inverter.

The protective layer 162 may be a solder mask, which is configured to protect its underlying conductive layer and other functional film layers from external environment erosion. In addition, the protective layer may also be provided on a lower surface of the double-sided chip-embedded circuit board, so as to provide dual protection for the double-sided chip-embedded circuit board, ensuring stable operation of the double-sided chip-embedded circuit board.

An embodiment of the present disclosure further provides a manufacturing method for a double-sided chip-embedded circuit board, which is used for manufacturing a double-sided chip-embedded circuit board according to any one of the above embodiments. Both the features and principles of the double-sided chip-embedded circuit board described in the above embodiments may be applied to the following embodiments of the manufacturing method. In the following embodiments of the manufacturing method, the features and principles of the double-sided chip-embedded circuit board that have been described will not be described herein again.

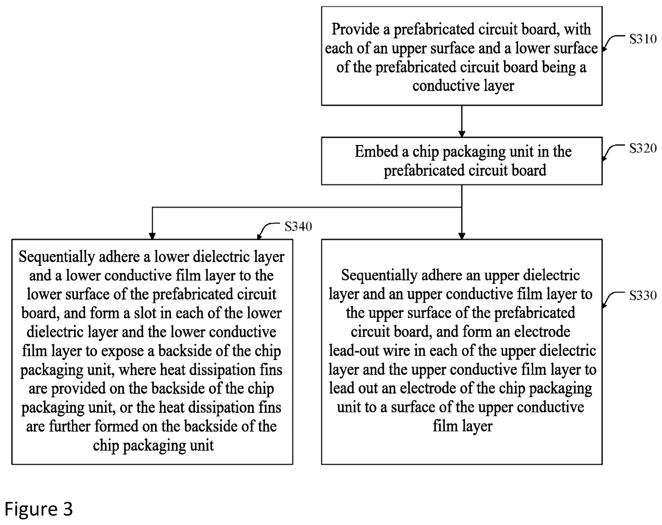

FIG. 3 illustrates main steps of a manufacturing method for a double-sided chip-embedded circuit board. Referring to FIG. 3 and in conjunction with FIG. 1 and FIG. 2, the manufacturing method for a double-sided chip-embedded circuit board according to an embodiment of the present disclosure includes:
S310: providing a prefabricated circuit board 110, with each of an upper surface and a lower surface of the prefabricated circuit board 110 being a conductive layer 111;
S320: embedding a chip packaging unit 120 in the prefabricated circuit board 110;
S330: sequentially adhering an upper dielectric layer 131 and an upper conductive film layer 132 to the upper surface of the prefabricated circuit board 110, and forming an electrode lead-out wire 124 in each of the upper dielectric layer 131 and the upper conductive film layer 132 to lead out an electrode of the chip packaging unit 120 to a surface of the upper conductive film layer 132; and
S340: sequentially adhering a lower dielectric layer 141 and a lower conductive film layer 142 to the lower surface of the prefabricated circuit board 110, and forming a slot in each of the lower dielectric layer 141 and the lower conductive film layer 142 to expose a backside of the chip packaging unit 120, where heat dissipation fins 126 are provided on the backside of the chip packaging unit 120, or the heat dissipation fins 126 are further formed on the backside of the chip packaging unit 120.

The order of execution of step S330 and step S340 may be adjusted as needed.

In the present disclosure, the upper conductive film layer 132 formed on the upper surface of the prefabricated circuit board 110 may be configured for leading out of the electrode of the chip packaging unit 120, connection to a power supply, and connection to drive/control and other circuit modules of an inverter, and the lower conductive film layer 142 formed on the lower surface of the prefabricated circuit board 110 may be configured for layout of other functional modules of the circuit board, such that the double-sided chip-embedded circuit board has a reasonable electrical performance layout and better stability. The double-sided chip-embedded circuit board of the present disclosure is specifically formed into a four-layer board structure, which not only improves the electrical performance of the double-sided chip-embedded circuit board, but also avoids an increase in cost due to an increasing number of conductive layers, thereby achieving a balance between cost and performance. In addition, the double-sided chip-embedded circuit board of the present disclosure also improves the heat dissipation performance through the heat dissipation fins 126 provided on the backside of the chip packaging unit 120, avoiding an impact on the heat dissipation of the chip packaging unit 120 due to the addition of the lower conductive film layer 142.

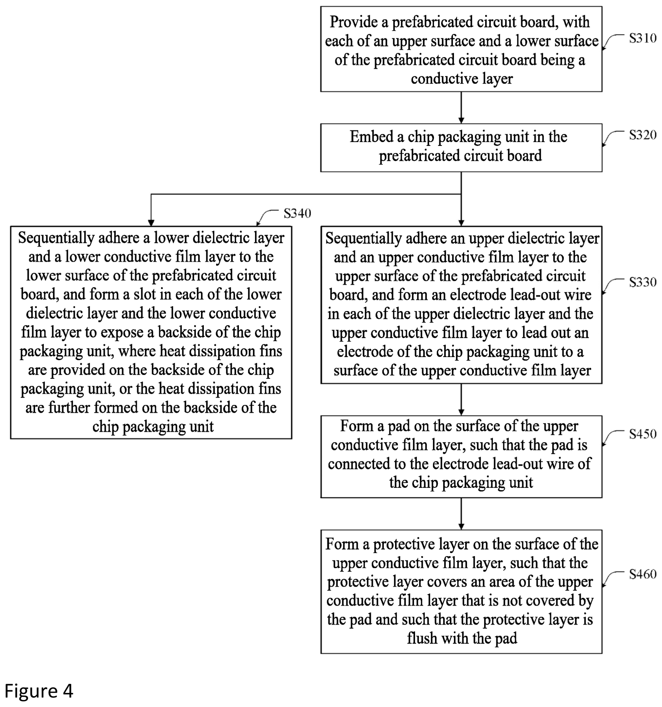

FIG. 4 illustrates main steps of another manufacturing method for a double-sided chip-embedded circuit board. Referring to FIG. 4 and in conjunction with FIG. 1 to FIG. 3, in some embodiments, the manufacturing method for a double-sided chip-embedded circuit board further includes:
5450: forming a pad 161 on the surface of the upper conductive film layer 132, such that the pad 161 is connected to an electrode lead-out wire 124 of the chip packaging unit 120; and
5460: forming a protective layer 162 on the surface of the upper conductive film layer 132, such that the protective layer 162 covers an area of the upper conductive film layer 132 that is not covered by the pad 161 and such that the protective layer is flush with the pad 161. In this way, the double-sided chip-embedded circuit board that may be used as the half-bridge module in the power module of the inverter is formed.

The above is a further detailed description of the present disclosure with reference to the specific preferred implementations, and it cannot be considered that the specific implementation of the present disclosure is limited to these descriptions. For those of ordinary skill in the art of the present disclosure, several simple deductions or substitutions can be further made without departing from the concept of the present disclosure, and should be regarded as falling within the scope of protection of the present disclosure.

## Claims

1. A double-sided chip-embedded circuit board, comprising:
a prefabricated circuit board, with each of an upper surface and a lower surface of the prefabricated circuit board being a conductive layer;
a chip packaging unit embedded in the prefabricated circuit board;
an upper conductive film layer adhered to the upper surface of the prefabricated circuit board by an upper dielectric layer and covering the chip packaging unit, wherein an electrode of the chip packaging unit is led out to a surface of the upper conductive film layer; and
a lower conductive film layer adhered to the lower surface of the prefabricated circuit board by a lower dielectric layer and exposing a backside of the chip packaging unit, wherein heat dissipation fins are provided on the backside of the chip packaging unit.

2. The double-sided chip-embedded circuit board according to claim 1, wherein the heat dissipation fins are uniformly distributed, and a diameter of each heat dissipation fin and/or a gap between adjacent heat dissipation fins is 1 mm to 2 mm.

3. The double-sided chip-embedded circuit board according to claim 1, wherein the chip packaging unit comprises a bus bar and a chip unit embedded in the bus bar, and the heat dissipation fins are provided on a backside of the bus bar, forming a structure that is recessed into the bus bar.

4. The double-sided chip-embedded circuit board according to claim 3, wherein there is a bus bar having a thickness of at least 1 mm between the heat dissipation fins and the chip unit.

5. The double-sided chip-embedded circuit board according to claim 1, wherein the heat dissipation fins are connected to the backside of the chip packaging unit, forming a structure that protrudes from the chip packaging unit.

6. The double-sided chip-embedded circuit board according to claim 5, wherein the heat dissipation fins are welded or adhesively bonded to the backside of the chip packaging unit.

7. The double-sided chip-embedded circuit board according to claim 1, wherein the heat dissipation fin s are recessed into an end face of the lower conductive film layer, such that a cooler insertion slot is reserved between the backside of the chip packaging unit and the lower conductive film layer and the lower dielectric layer.

8. The double-sided chip-embedded circuit board according to claim 1, further comprising:
a pad provided on the surface of the upper conductive film layer and connected to an electrode lead-out wire of the chip packaging unit; and
a protective layer covering an area of the upper conductive film layer that is not covered by the pad and being flush with the pad.

9. A manufacturing method for a double-sided chip-embedded circuit board, which is used for manufacturing a double-sided chip-embedded circuit board according to any one of claims 1 to 8, the manufacturing method comprising:
providing a prefabricated circuit board, with each of an upper surface and a lower surface of the prefabricated circuit board being a conductive layer;
embedding a chip packaging unit in the prefabricated circuit board;
sequentially adhering an upper dielectric layer and an upper conductive film layer to the upper surface of the prefabricated circuit board, and forming an electrode lead-out wire in each of the upper dielectric layer and the upper conductive film layer to lead out an electrode of the chip packaging unit to a surface of the upper conductive film layer; and
sequentially adhering a lower dielectric layer and a lower conductive film layer to the lower surface of the prefabricated circuit board, and forming a slot in each of the lower dielectric layer and the lower conductive film layer to expose a backside of the chip packaging unit, wherein
heat dissipation fins are provided on the backside of the chip packaging unit, or the heat dissipation fins are further formed on the backside of the chip packaging unit.

10. The manufacturing method according to claim 9, further comprising:
forming a pad on the surface of the upper conductive film layer, such that the pad is connected to an electrode lead-out wire of the chip packaging unit; and
forming a protective layer on the surface of the upper conductive film layer, such that the protective layer covers an area of the upper conductive film layer that is not covered by the pad and such that the protective layer is flush with the pad.
